(19) Europäisches Patentamt

European Patent Office

Office européen des brevets

(11) Veröffentlichungsnummer: **0 304 772 B1**

(12) **EUROPÄISCHE PATENTSCHRIFT**

(45) Veröffentlichungstag der Patentschrift: **15.07.92**

(51) Int. Cl.⁵: $H05K\ 7/14$

(21) Anmeldenummer: **88113275.7**

(22) Anmeldetag: **16.08.88**

(54) **Frontstecksystem mit nacheilender Endkontaktvorrichtung.**

(30) Priorität: **28.08.87 DE 3728865**

(43) Veröffentlichungstag der Anmeldung:
**01.03.89 Patentblatt 89/09**

(45) Bekanntmachung des Hinweises auf die
Patenterteilung:
**15.07.92 Patentblatt 92/29**

(84) Benannte Vertragsstaaten:
**AT CH DE ES FR GB IT LI NL SE**

(56) Entgegenhaltungen:
**EP-A- 0 129 883**
**EP-A- 0 165 434**
**DE-A- 2 928 668**
**DE-A- 3 603 643**
**US-A- 4 151 580**

(73) Patentinhaber: **SIEMENS AKTIENGESELL-
SCHAFT**
**Wittelsbacherplatz 2**
**W-8000 München 2(DE)**

(72) Erfinder: **Rieck, Norbert**
**Trübnerstrasse 14**
**W-8500 Nürnberg(DE)**
Erfinder: **Vache, Peter**
**Adelsgasse 9**
**W-8551 Heroldsbach(DE)**

Rank Xerox (UK) Business Services

# Beschreibung

Die Erfindung betrifft ein Frontstecksystem für eine Flachbaugruppe aus einem Frontelement und einem mittels einer Schwenkbewegung aufsteckbaren Frontsteckverbinder gemäß dem Oberbegriff von Anspruch 1.

Bei elektrischen Schaltungen, die meist stark komprimiert mit integrierten Schaltkreisen auf Flachbaugruppen aufgebaut sind, werden häufig bestimmte Signale bzw. ganze Signalgruppen, z.B. Datenbusse, nach außen an den "Rand" der Flachbaugruppe geführt. Signale dieser Art können dann bevorzugt zu Schaltungsdiagnose-, Anzeige-, Überwachungs- und Meßzwecken insbesondere an der Frontseite der Flachbaugruppe angezeigt werden, bzw. sind dort bei Bedarf abgreifbar und über zusätzliche Verbindungen weiterleitbar. Im Gegensatz dazu werden Signale bzw. Signalgruppen, die ständig zwischen insbesondere auf mehreren Flachbaugruppen verteilten Schaltungsteilen ausgetauscht werden müssen, bevorzugt über ortsfeste Flachbandkabelverbindungen bzw. feste Verdrahtungen insbesondere an den Rückseiten von Baugruppenträgern weitergeleitet.

Zum Auflegen und Abgreifen elektrischer Signale an den Stirnseiten von insbesondere im engen Verbund parallel nebeneinander in Baugruppenträgern angeordneten Baugruppen dienen Frontsysteme aus einem mit der jeweiligen Baugruppe fest verbundenen Frontelement und einem bei Bedarf darauf aufsteckbaren Frontsteckverbinder. So ist z.B. der europäischen Patentanmeldung mit der Veröffentlichungsnummer 0 129 883 und der Anmeldenummer 84107202.8 ein Frontsystem für in Baugruppenträger einschiebbare Baugruppen und rahmenartige Baugruppenträger zu deren Aufnahme zu entnehmen. Dabei ist auf der Frontleiste der jeweiligen Flachbaugruppe eine Steckfassung zur Aufnahme eines Frontsteckers angebracht, womit bestimmte elektrische Signale bevorzugt über ein Kabel abgeleitet werden können. Eine solche Anordnung hat aber den Nachteil, daß ein in der Steckfassung sitzender Frontstecker nicht oder nur mit einem zusätzlichen Aufwand gegen ein versehentliches Abziehen gesichert werden kann. Desweiteren schließen sich bei einem Steckvorgang die Kontakte in einer nicht vorhersehbaren, zufälligen Reihenfolge. Zur Vermeidung von Rückwirkungen auf die auf der Flachbaugruppe befindlichen Schaltung kann es somit unter Umständen vor dem Steckvorganges notwendig sein, diese Schaltung bzw. bei mehreren, in einem Träger zusammengefaßten Baugruppen die gesamte Vorrichtung insbesondere durch Trennung von der Stromversorgung kurzzeitig vollständig außer Betrieb zu nehmen.

Der deutschen Patentschrift mit der Veröffentlichungsnummer 28 50 093 ist desweiteren eine Halterungsanordnung für Schaltungsplatten zu entnehmen. Je ein der jeweiligen Schaltungsplatte zugeordnetes elektrisches Verbindungsglied ist dabei von einer Wartestellung aus in eine Betriebsstellung schwenkbar, in welcher es an der Schaltungsplatte eingreift. Auch diese Anordnung hat den Nachteil, daß die an der Stirnseite der Schaltungsplatte befindlichen Kontakte beim Übergang z.B. von der Warte- in die Betriebsstellung nicht gleichzeitig geschlossen werden. In einem Gerät, dem diese abgegriffenen Signale zu einer weiteren Verarbeitung zugeführt werden, können somit unter Umständen zumindest vorübergehend Fehlfunktionen auftreten. Desweiteren ist auch bei dieser Anordnung das elektrische Verbindungsglied nicht gegen zufälliges bzw. unzulässiges Wegschwenken in die Wartestellung gesichert.

Ein Frontstecksystem gemäß dem Oberbegriff des Anspruchs 1 ist aus EP-A-0 165 434 bekannt.

Der Erfindung liegt somit die Aufgabe zugrunde, ein aus einem Frontelement und einem aufsteckbaren Frontsteckverbinder bestehendes Frontstecksystem so zu gestalten, daß z.B. bei einem Aufsteckvorgang des Frontsteckverbinders die damit abgreifbaren Signale erst dann auf den Frontsteckverbinder und eine möglicherweise daran angeschlossene weitere Vorrichtungen durchgeschaltet werden können, nachdem alle Arbeitskontakte auf Frontelement und Frontsteckverbinder elektrisch leitend miteinander verbunden sind.

Die Aufgabe wird gelöst durch die kennzeichnenden Merkmale des Anspruches 1. Die Unteransprüche enthalten weitere vorteilhafte Ausgestaltungen des erfindungsgemäßen Frontstecksystems.

Das erfindungsgemäße Frontstecksystem hat den besonderen Vorteil, daß aufgrund der bei einem Aufsteckvorgang des Frontsteckverbinders nacheilenden Endkontaktvorrichtung z.B. über eine auf der Flachbaugruppe befindliche und durch die Endkontaktvorrichtung ausgelöste Steuerung die elektrischen Signale für alle Arbeitskontakte z.B. durch Aktivierung eines Daten-Latches nahezu gleichzeitig freigegeben werden können. Ferner wird mit Hilfe der Erfindung eine sichere Sitzüberwachung des Frontsteckverbinders ermöglicht, da die Endkontaktvorrichtung nur in Verbindung mit einer Verriegelung des Frontsteckverbinders auf dem Frontelement über die Verschlußvorrichtung in Eingriff kommt. Schließlich ist es ein weiterer Vorteil des erfindungsgemäßen Frontstecksystems, daß bei einem Abziehvorgang des Frontsteckverbinders durch Entriegeln der Verschlußvorrichtung die Endkontaktvorrichtung mit Sicherheit vor der Unterbrechung irgendeines Arbeitskontaktes außer Eingriff gebracht wird. Somit verbleibt in der Regel noch ausreichend Zeit, um geeignete Sicherungsmaßnahmen durchführen zu können. Diese können in der Auslösung einer Alarmfunktion bestehen, bzw. es können Datensicherungs- und Abschlußroutinen ausgelöst und möglichst vor der eigentlichen Unterbrechung der Arbeitskontakte beendet werden.

Anhand der nachfolgend kurz angeführten Figuren wird die Erfindung desweiteren näher erläutert. Dabei zeigt:

FIG 1 eine vorteilhafte Ausführungsform des erfindungsgemäßen Frontstecksystems aus einem Frontelement mit eingehängtem Frontsteckverbinder,

FIG 2 eine Detaildarstellung eines Teils des Frontsteckverbinders gemäß der Ausführungsform von FIG 1,

FIG 3 eine weitere vorteilhafte Ausführungsform des erfindungsgemäßen Frontstecksystems,

FIG 4 eine Detaildarstellung eines Teils des Frontsteckverbinders gemäß der Ausführungsform von FIG 3,

FIG 5 einen Teil einer Aufnahmevorrichtung für Anzeigeelemente in Draufsicht, wobei anstelle eines der Anzeigeelemente ein erfindungsgemäßes Kontaktgegenstück eingesetzt ist,

FIG 6 eine Schnittdarstellung des Teils der Aufnahmevorrichtung von FIG 5,

FIG 7 eine bevorzugte Ausführungsform eines erfindungsgemäßen Kontaktstiftes, und

FIG 8 eine Schnittdarstellung durch eine im Eingriff befindliche Endkontaktvorrichtung mit den in den FIG 5,6 und 7 dargestellten bevorzugten Ausführungsformen von Kontaktstück und Kontaktgegenstück.

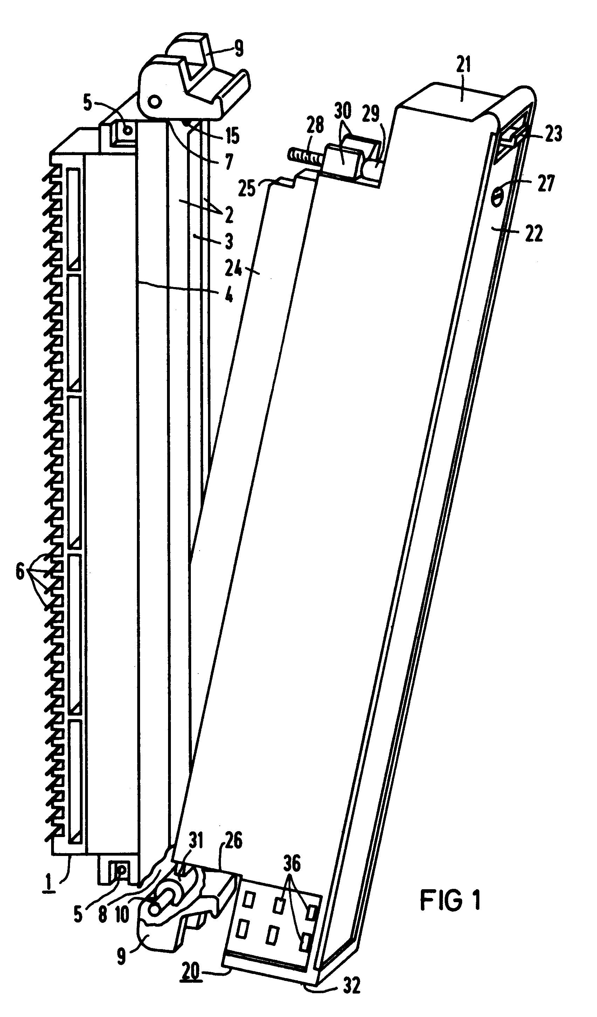

Das erfindungsgemäße Frontstecksystem besteht aus einem Frontelement 1, in das gemäß der Darstellung von FIG 1 ein Frontsteckverbinder 20 eingehängt ist. Dieser ist über ein an dem anderen, insbesondere dem unteren Ende 26 angebrachtes Drehlager 31 in eine Abstützvorrichtung einhängbar und dort drehbar gelagert. Die Abstützvorrichtung selbst besteht vorteilhaft aus einem Bolzen 10, der am unteren Ende 8 des Frontelementes 1 angebracht ist und bevorzugt gleichzeitig als Lager für einen von möglicherweise zusätzlich vorhandenen Aushebegriffen 9 dient. Der Frontsteckverbinder 20 kann mittels einer Schwenkbewegung um den Bolzen 10 als Drehpunkt auf das Frontelement 1 aufgesteckt werden. Hierdurch werden elektrische Arbeitskontakte geschlossen, welche in vom einen Ende 7 bzw.25 zum anderen Ende 8 bzw.26 auf dem Frontelement bzw. dem Frontsteckverbinder verlaufenden Aufnahmevorrichtungen angebracht sind. In der in der FIG 1 dargestellten bevorzugten Ausführungsform ist die Aufnahmevorrichtung 3 auf der Stirnseite 2 des Frontelementes 1 beispielsweise schlitzförmig ausgebildet, und enthält bevorzugt die Kontaktmesser der Arbeitskontakte. In diesen Aufnahmeschlitz greift die bevorzugt balkenförmig ausgebildete Aufnahmevorrichtung 24 des Frontsteckverbinders 20 ein, welche bevorzugt die Kontaktfedern der Arbeitskontakte enthält. Die Lagerung der Teile der Arbeitskontakte in jeweils schlitz- und balkenförmig ausgebildeten Aufnahmevorrichtungen hat den besonderen Vorteil, daß bei einem schwenkenden Aufstecken der Frontsteckverbinder 20 aufgrund des gegenseitigen Eingriffes der beiden Aufnahmevorrichtungen 3 und 24 geführt wird. Auf diese Weise ist ein versehentliches Abkanten und damit die Gefahr einer Beschädigung der Arbeitskontakte nahezu ausgeschlossen.

Das Frontelement 1 wird bevorzugt mit Hilfe von Bohrungen 5 mechanisch mit einer Flachbaugruppe verbunden, welche zur besseren Übersicht in der FIG 1 nicht dargestellt ist. Dabei greifen Kontaktstifte 6, welche bevorzugt an einer Längsseite des Frontelementes angeordnet sind, bevorzugt in auf der Flachbaugruppe befindliche Bohrungen ein und können dort insbesondere durch Verlöten mit Leiterbahnen kontaktiert werden. Auf diese Weise können bestimmte elektrische Signale der auf der Flachbaugruppe befindlichen Schaltung nach "außen" geführt werden, und liegen an den in der Aufnahmevorrichtung 3 des Frontelementes 1 angeordneten Teilen der Arbeitskontakte an. Nach Aufstecken des Frontsteckverbinders sind diese elektrischen Signale insbesondere über ein in dessen Inneren an der Rückseite der Arbeitskontakte angeschlossenes Kabel weiterleitbar. Dieses kann bevorzugt über einen Schacht 32 am unteren Ende 26 des Frontsteckverbinders 20 nach außen geführt werden.

Als erfindungsgemäße Endkontaktvorrichtung dient in diesem Ausführungsbeispiel besonders vorteilhaft der letzte Arbeitskontakt an dem anderen, nicht mit dem Drehpunkt für die Schwenkbewegung des Frontsteckverbinders versehenen Endes 7,25 des Frontstecksystems. Dieser Arbeitskontakt ist bevorzugt gegenüber den übrigen Arbeitskontakten zurückgesetzt angeordnet, was in der FIG 1 beispielhaft durch eine Stufe am oberen Ende 25 der balkenförmigen Aufnahmevorrichtung 24 des Frontsteckverbinders dargestellt ist. Gleichzeitig bzw. anstelle davon kann auch der gegenüberliegend im schlitzförmigen Aufnahmeschacht 3 des Frontelementes 1 angeordnete Teil dieses Arbeitskontaktes gegenüber den übrigen Teilen zurückgesetzt sein.

Es ist ein wesentliches Kennzeichen der Erfindung, daß die Endkontaktvorrichtung nur bei der Bedienung einer am Frontstecksystem zusätzlich vorhandenen Verschlußvorrichtung in Eingriff kommt. Der Frontsteckverbinder ist also über die Schwenkbewegung auf das Frontelement nur soweit aufsteckbar, bis der Eingriffspunkt der Verschlußvorrichtung erreicht ist. Die Verschlußvorrichtung ist so gestaltet, daß in diesem Zustand die Aufnahmevorrichtungen von Frontelement und Frontsteckverbinder bereits ineinander eingegriffen haben und alle Arbeitskontakte mit Sicherheit geschlossen sind. Der vollständig aufgesteckte Zustand wird aber erst durch eine zusätzliche Bedienung der Verschlußvorrichtung erreicht. Hierdurch wird der letzte Schließweg überwunden, die Endkontaktrichtung in Eingriff gebracht und gleichzeitig der Frontsteckverbinder gegen Abziehen verriegelt.

In der bevorzugten Ausführungsform der FIG 1 ist die Verschlußvorrichtung gemeinsam mit der Endkontaktvorrichtung an dem anderen Ende 7 bzw. 25 des Frontstecksystems angebracht. Die Verschlußvorrichtung selbst besteht besonders vorteilhaft aus mindestens einer durch den Frontsteckverbinder 20 hindurchgeführten Schraube und mindestens einem gegenüberliegend im Frontelement 1 gelagerten Innengewinde. Eine bereits in der FIG 1 dargestellte Schraube 27 ist bevorzugt über eine Halterung 30 und einen Schraubenschaft 29 mit vergrößertem Außendurchmesser im Frontsteckverbinder gelagert. Das Aufstecken des Frontsteckverbinders ist zunächst nur soweit möglich, bis das Schraubengewinde 28 am Eingang des Innengewindes 15 anschlägt. Die Arbeitskontakte der Aufnahmevorrichtungen 3 und 24 sind in diesem Zustand bereits geschlossen. Aufgrund der zurückgesetzten Anordnung des in dieser Ausführungsform als Endkontaktvorrichtung dienenden Arbeitskontaktes am oberen Ende 7 bzw. 25 des Frontstecksystems wird dieser erst dann geschlossen, wenn durch Einschrauben der Schraube 27 in das Innengewinde 15 der Frontsteckverbinder 20 vollständig an das Frontelement 1 herangezogen ist. Durch eine geeignete Auswahl der Länge des Schraubengewindes 28 kann insbesondere für den Fall einer Entriegelung der Verschlußvorrichtung durch Herausdrehen der Schraube auf einfache Weise eine ausreichende "Verzugszeit" eingestellt werden, um zwischen der Unterbrechung der Endkontaktrichtung und der Unterbrechung einer der Arbeitskontakte Sicherungsmaßnahmen auslösen und möglichst auch beenden zu können.

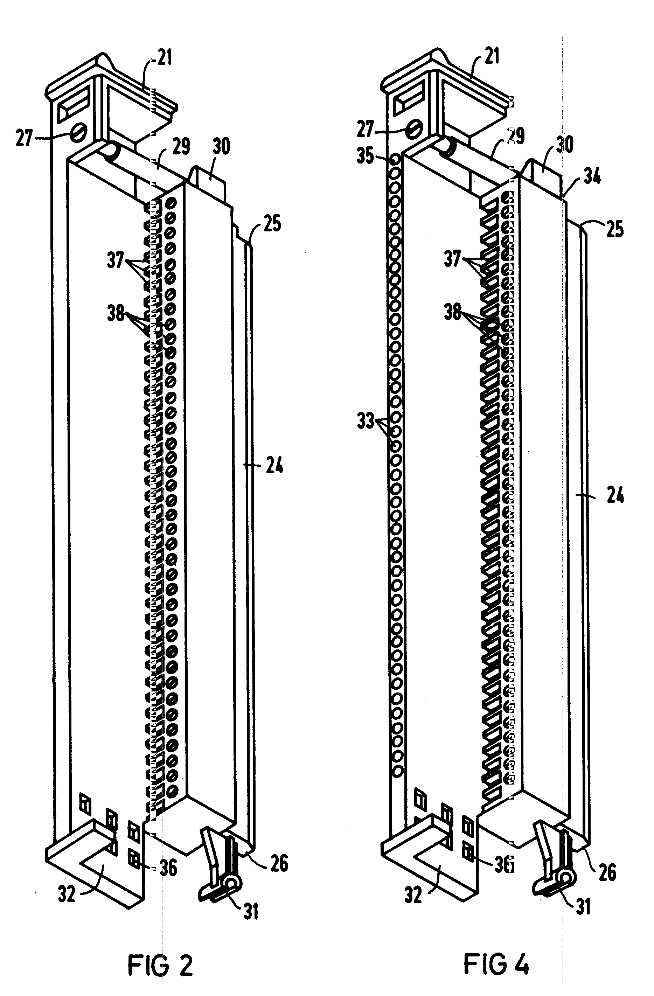

Da der Frontsteckverbinder bevorzugt ein Hilfsmittel dafür ist, um die elektrischen Signale der Arbeitskontakte in ein Kabel überzuleiten, ist es besonders vorteilhaft, den Frontsteckverbinder zweiteilig auszuführen. Dies ist bereits im Ausführungsbeispiel der FIG 1 dargestellt. Der dortige Frontsteckverbinder besteht aus einem Grundkörper 21 und einer abnehmbaren, bevorzugt mittels einer Klemmnase 23 arretierbaren Abdeckung 22. FIG 2 zeigt einen möglichen inneren Aufbau eines Frontsteckverbinders bei abgenommener Abdekkung. Auf der der Aufnahmevorrichtung 24 gegenüberliegenden Innenseite des Grundkörpers 21 sind dabei bevorzugt je eine Klemmenleiste 37 und eine Schraubenleiste 38 zum Spannen der einzelnen Klemmen angebracht. Auf diese Weise können die Adern eines über den Schacht 36 am unteren Ende 26 des Frontsteckverbinders eingelegten Kabels besonders vorteilhaft an die in der Aufnahmevorrichtung 24 befindlichen Teile der Arbeitskontakte angeschlossen werden. Schließlich kann das Kabel bevorzugt über Kabelbinder, welche durch die Ausbrüche 36 geführt sind, am Grundkörper 21 befestigt werden. In einer weiteren Ausführungsform ist es auch möglich, den Frontsteckverbinder z.B. als eine Art Programmierstecker zu verwenden. Hierzu können Kurzschlußverbindung zwischen einzelnen Klemmen der Arbeitskontakte gelegt werden. Das erfindungsgemäße Frontstecksystem ermöglicht in diesem Fall bei Bedarf eine besonders einfache Korrektur der vorhandenen Verbindungen bzw. eine Neuverdrahtung, indem durch vorübergehendes Entriegeln der Verschlußvorrichtung die Endkontaktvorrichtung außer Eingriff gebracht wird. Der Frontsteckverbinder braucht hierbei nicht abgenommen zu werden.

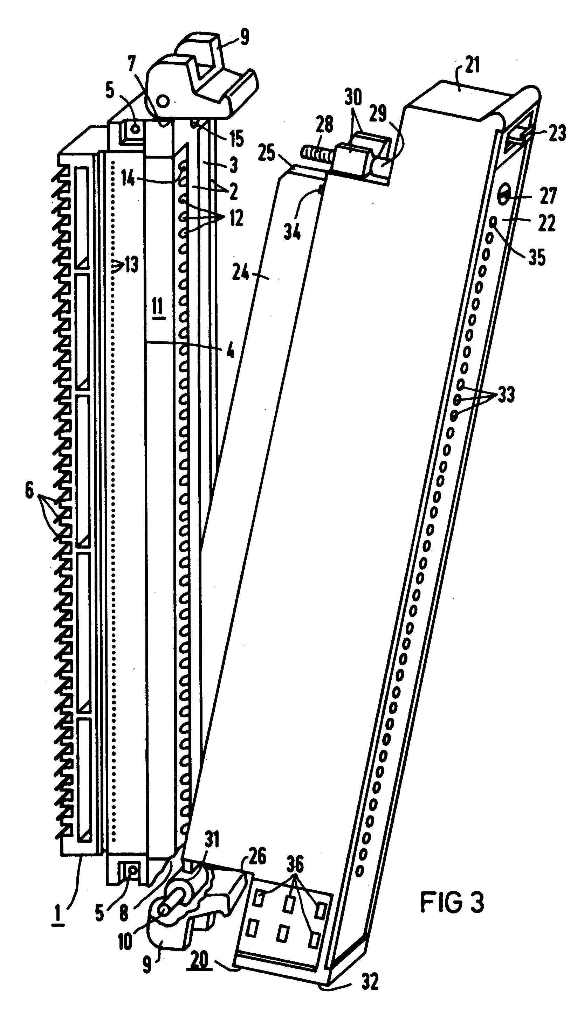

Eine weitere vorteilhafte Ausführungsform der erfindungsgemäßen Endkontaktvorrichtung ist in der FIG 3 dargestellt. Das Frontstecksystem enthält in diesem Fall zusätzliche Anzeigeelemente 12, welche in einer weiteren, bevorzugt parallel zur Aufnahmevorrichtung 3 für die Arbeitskontakte angeordneten Aufnahmevorrichtung 11 untergebracht sind. Als Anzeigeelemente eignen sich besonders Leuchtdioden, welche auf der Innenseite einer an einer Längsseite des Frontelementes angebrachten Muldenleiste 4 eingelegt sind. Die Zuleitungen der Anzeigeelemente werden bevorzugt über eine an einer Längskante der Muldenleiste 4 befindlichen Bohrungsreihe 13 nach außen geführt und können dort z.B. mit Leiterbahnen der Flachbaugruppe verbunden werden. Bevorzugt entspricht die Anzahl der Anzeigeelemente 12 gerade der Anzahl der Arbeitskontakte in den Aufnahmevorrichtungen 3 und 24, so daß auf diese Weise z.B. die aktiven Zustände der auf die Arbeitskontakte gelegten Signale der elektrischen Schaltung der Flachbaugruppe optisch sichtbar gemacht werden können.

In der Ausführungsform der FIG 3 steht der Frontsteckverbinder im aufgesteckten Zustand über die Anzeigeelemente hinweg. Insbesondere mittels zusätzlicher, dem jeweiligen Anzeigeelement gegenüberliegende Bohrungen 33 im Frontsteckverbinder können die Anzeigeelemente sichtbar gemacht werden. Es ist nun besonders vorteilhaft, wenn bei Bedarf anstelle eines der Anzeigeelemente die Endkontaktvorrichtung eingesetzt wird. Alle Arbeitskontakte stehen somit noch zur Signalübertragung zur Verfügung. Weiterhin müssen keine mechanischen Veränderungen insbesondere bei der Gestaltung der Aufnahmevorrichtungen und der Lage der Arbeitskontakte vorgesehen werden.

Besonders vorteilhaft wird gerade das an dem oberen, anderen Ende 7 bzw. 25 des Frontstecksystems befindliche Anzeigeelement durch die Endkontaktvorrichtung ausgetauscht. So ist entsprechend der Darstellung von FIG 3 im Frontelement anstelle des Anzeigeelementes 14 ein Teil der Endkontaktvorrichtung eingesetzt. Gegenüberliegend ist auf dem Frontsteckverbinder ein mit dem Bezugszeichen 34 versehenes weiteres Teil der Endkontaktvorrichtung dargestellt.

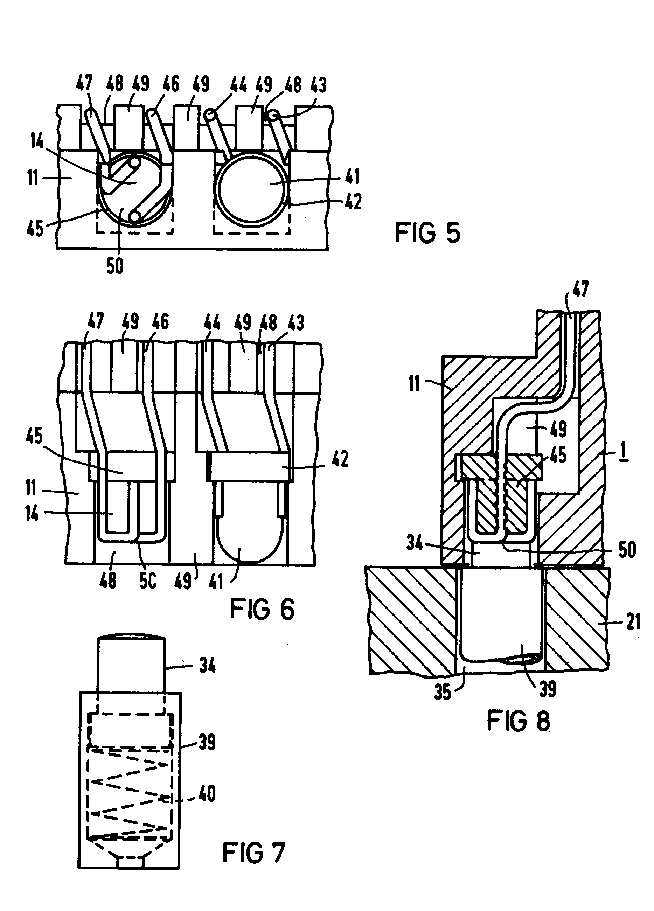

FIG 4 zeigt eine der FIG 2 entsprechende Ansicht des Frontsteckverbinders gemäß der Ausführungsform von FIG 3 bei abgenommener Abdeckung 22. Auch hier sind die Bohrungen 33 im Grundkörper 21 zur Sichtbarmachung der einzelnen Anzeigeelemente zu erkennen.

Eine besonders vorteilhafte Ausführungsform für eine insbesondere anstelle eines der Anzeigeelemente in der FIG 3 einsetzbaren Endkontaktvorrichtung ist in den FIG 5 bis 8 dargestellt. Diese besteht aus einem Kontaktgegenstück 14 und einem Kontaktstift 39. Wie in den FIG 5 und 6 dargestellt, ist das Kontaktgegenstück an die äußere Form eines der Anzeigeelemente angepaßt. In der dargestellten Ausführungsform hat das Kontaktgegenstück 14 annähernd die Form einer Leuchtdiode 41. Desweiteren sind die Zuleitungen 46 und 47 in der gleichen Weise geführt wie die Zuleitungen 43 und 44 der Leuchtdiode 41. Somit ist es bei Bedarf jederzeit ohne großen Aufwand möglich, eines der Anzeigeelemente durch ein derartig gestaltetes Kontaktgegenstück auszutauschen. Die Detaildarstellungen der FIG 5 und 6 zeigen desweiteren einen Ausschnitt eines möglichen Aufbaues der Innenseite der weiteren Aufnahmevorrichtung 11. Insbesondere über Mulden 48 und dazwischen angeordnete Stege 49 ist die Innenseite der Form der aufzunehmenden Anzeigeelemente bzw.des Kontaktgegenstückes 14 und deren Zuleitungen 43,44,46 und 47 so angepaßt, daß alle eingelegten Elemente gegen Verschieben bzw. Herausfallen gesichert sind.

Das Kontaktgegenstück 14 besteht bevorzugt aus einem Isolierkörper 45, auf dessen Kontaktfläche 50 die elektrischen Zuleitungen 46 und 47 geführt sind und dessen Form z.B. der Form eines Diodenträgers 42 mit eingesetztem Diodenglaskörper 41 entspricht. In dem durch Bedienung des Verschlußelementes erreichbaren vollständig auf dem Frontelement aufgesteckten Zustand des Frontsteckverbinders werden diese Zuleitungen bevorzugt durch einen auf der Kontaktfläche 50 aufliegenden, metallischen Kontaktstift kurzgeschlossen. In FIG 7 ist eine vorteilhafte Ausführungsform eines solchen bevorzugt zylindrischen Kontaktstiftes 39 dargestellt. In diesem ist ein über eine Feder 40 abgestütztes Kontaktstück 34 eingelassen, mit dessen Hilfe die eigentliche Kontaktierung durchgeführt wird.

Es ist besonders vorteilhaft, wenn der Kontaktstift über eine solche äußere Form verfügt, daß dieser in der dem Kontaktstück gegenüberliegenden Bohrung 35 gelagert werden kann, welche ursprünglich zur Sichtbarmachung des durch das Einsetzen des Kontaktstückes entfallenen Anzeigeelementes diente. FIG 8 zeigt eine solche Anordnung. Alle übrigen Bohrungen 33 können schließlich zur besseren Sichtbarmachung des am Ende der jeweiligen Bohrung befindlichen Anzeigeelementes vorteilhaft mit einem insbesondere aus einem glasartigen Kunststoff bestehenden Lichtleiter ausgefüllt werden.

**Patentansprüche**

1. Frontstecksystem für eine Flachbaugruppe aus einem Frontelement (1) und einem mittels einer Schwenkbewegung aufsteckbaren Frontsteckverbinder (20), mit einer Abstützvorrichtung (10) an dem einen Ende (8) des Frontelementes zum Einhängen des Frontsteckverbinders über ein Drehlager (31), mit je einer vom einen zum anderen Ende auf dem Frontelement bzw. dem Frontsteckverbinder (7,8 bzw.25,26) verlaufenden Aufnahmevorrichtung (3,24) für elektrische Arbeitskontakte und einer Verschlußvorrichtung (15,27) **gekennzeichnet durch** eine Endkontaktvorrichtung (14,39) an dem anderen Ende (7,25) des Frontstecksystems zum Durchschalten der mit dem Frontsteckverbinder (20) abgriefbaren Signale auf den Frontsteckverbinder (20), wobei nach dem Aufstecken des Frontsteckverbinders (20) bis zum Erreichen des Eingriffspunktes der Verschlußvorrichtung (15,27) und dem Schließen der Arbeitskontakte die Endkontaktvorrichtung (14,39) erst dann in Eingriff kommt, nachdem aufgrund einer Bedienung der Verschlußvorrichtung der Frontsteckverbinder (20) vollständig auf dem Frontelement (1) aufgesteckt ist.

2. Frontstecksystem nach Anspruch 1, **dadurch gekennzeichnet**, daß die Verschlußvorrichtung an dem anderen Ende (7,25) des Frontstecksystems angeordnet ist.

3. Frontstecksystem nach Anspruch 2, **gekennzeichnet durch** mindestens eine durch den Frontsteckverbinder (20) hindurchgeführte Schraube (27) mit gegenüberliegend im Frontelement (1) befindlichem Innengewinde (15) als Verschlußvorrichtung, wobei die Schraube (28) soweit aus dem Frontsteckverbinder herausragt, daß bei Anschlagen des Schraubenendes am Eingang des Innengewindes alle Arbeitskontakte geschlossen sind und die Endkontaktvorrichtung erst nach vollständigem Einschrauben der Schraube in das Innengewinde in Eingriff kommt (FIG 1 bis 4).

4. Frontstecksystem nach einem der vorangegangenen Ansprüche, **gekennzeichnet durch** eine schlitzförmige Aufnahmevorrichtung (3) insbesondere für die Kontaktmesser der elektrischen Arbeitskontakte, in welche nach Aufstecken des Frontsteckverbinders auf das Frontelement eine balkenförmig vorstehende Aufnahmevorrichtung (24) insbesondere für die komplementär angeordneten Kontaktfedern der elektrischen Arbeitskontakte eingreift (FIG 1 und 3).

5. Frontstecksystem nach Anspruch 4 mit einer Endkontaktvorrichtung, **dadurch gekennzeichnet**, daß der an dem anderen Ende (7,25) des Frontstecksystems befindliche Arbeitskontakt gegenüber den übrigen Arbeitskontakten zurückgesetzt angeordnet ist und erst nach Bedienung der Verschlußvorrichtung in Eingriff kommt (FIG 1 und 2).

6. Frontstecksystem nach einem der vorangegangenen Ansprüche 1 bis 4 mit einer weiteren, auf dem Frontelement (1) angeordneten Aufnahmevorrichtung (11) für Anzeigeelemente (12), bevorzugt Leuchtdioden (41), für elektrische Signale, welche bei aufgestecktem Frontsteckverbinder (20) abdeckt wird, **gekennzeichnet durch** den Anzeigeelementen (12) im aufgesteckten Zustand gegenüberliegende und diese sichtbar machende Bohrungen (33) im Frontsteckverbinder (20), wobei anstelle eines an dem anderen Ende (7,25) des Frontstecksystems befindlichen Anzeigeelementes die Endkontaktvorrichtung (14,34) eingesetzt ist (FIG 3 und 4).

7. Frontstecksystem nach Anspruch 6 mit einer Endkontaktvorrichtung, **gekennzeichnet durch**
   a) ein Kontaktgegenstück (14) aus einem an die Form eines der Anzeigeelemente angepaßten Isolierkörper (45) mit auf dessen Kontaktfläche (50) geführten elektrischen Zuleitungen (46,47), und
   b) einen bevorzugt zylindrischen Kontaktstift (39) mit einem eingelassenen, federnden Kontaktstück (34), wobei der Kontaktstift auf der dem Frontelement (1) zugewandten Seite in der an dem anderen Ende (25) des Frontsteckverbinders befindlichen Bohrung (35) gelagert ist. (FIG 5 bis 8)

8. Frontstecksystem nach einem der Ansprüche 6 und 7, **dadurch gekennzeichnet**, daß auf dem Frontsteckverbinder alle Bohrungen (33) außer der zur Aufnahme des Kontaktstiftes (39) dienenden (35) mit einem Lichtleiter insbesondere aus glasartigem Kunststoff ausgefüllt sind.

**Claims**

1. Front plug system for a flat structural component comprising a front element (1) and a front plug connector (20), which can be attached by means of a pivot movement, having a supporting device (10) at one end (8) of the front element for suspending the front plug connector by means of a pivot bearing (31), having in each case a receiving arrangement (3,24) for electrical operating contacts, the receiving arrangement extending from one end to the other on the front element or the front plug connector (7,8 or 25,26), and a closure device (15,27), characterized by an end contact device (14,39) at the other end (7,25) of the front plug system for switching through the signals which can be picked up by the front plug connector (20) to the front plug connector (20), whereby after the attachment of the front plug connector (20), until the contact point of the closure device (15,27) is reached and the operating contacts are closed, the end contact device (14,39) only engages after the front plug connector (20) is attached completely to the front element (1) due to an operation of the closure device.

2. Front plug system according to claim 1, characterized in that the closure device is arranged at the other end (7,25) of the front plug system.

3. Front plug system according to claim 2, characterized by at least one screw (27) guided through the front plug connector (20) with internal thread (15) as closure device located opposite in the front element (1), whereby the screw (28) projects so far out of the front plug connector that when the end of the screw stops at the inlet of the internal thread all operating contacts are closed and the end contact device only engages after the screw has been screwed completely into the internal thread (Figures 1 to 4).

4. Front plug system according to one of the preceding claims, characterized by a slot-shaped receiving arrangement (3) in particular for the contact measuring devices of the electrical operating contacts, into which, after the attachment of the front plug connector to the front element, a receiving arrangement (24), projecting in a bar-shaped manner, engages, in particular for the contact springs of the electrical operating contacts which are arranged in a complementary manner (Figures 1 and 3).

5. Front plug system according to claim 4, having an end contact device, characterized in that the operating contact located at the other end (7,25) of the front plug system is arranged so that it is set back relative to the remaining operating contacts and only engages after the operation of the closure device (Figures 1 and 2).

6. Front plug system according to one of the preceding claims 1 to 4, with an additional receiving arrangement (11) arranged on the front element (1) for display elements (12), preferably light diodes (41), for electrical signals, which are covered when the front plug connector (20) is attached, characterized by openings (33) in the front plug connector (20) which lie opposite the display elements (12) in the attached state and make them visible, whereby in place of a display element located at the other end (7,25) of the front plug system, the end contact device (14,34) is inserted (Figures 3 and 4).

7. Front plug system according to claim 6, having an end contact device, characterized by
   a) a contact counterpart (14) consisting of an insulating body (45) adapted to the shape of one of the display elements, having electrical supply lines (46,47) guided on to its contact area (50), and
   b) a preferably cylindrical contact pin (39) having an inset, resilient contact piece (34), whereby the contact pin on the side facing the front element (1) is mounted in the opening (35) located at the other end (25) of the front plug connector (Figures 5 to 8).

8. Front plug system according to one of claims 6 and 7, characterized in that on the front plug connector all openings (33) apart from the one (35) serving to pick up the contact pin (39) are filled with a light guide, in particular of glass-type plastic.

**Revendications**

1. Système d'enfichage frontal pour un module plat, constitué par un élément frontal (1) et un connecteur frontal (20), qui peut être enfiché au moyen d'un mouvement de pivotement, et comportant un dispositif de support (10) situé sur une extrémité (8) de l'élément frontal pour suspendre le connecteur frontal au moyen du palier rotatif (31), respectivement un dispositif (3,24) de logement de contacts électriques de travail, qui s'étend d'une extrémité à l'autre de l'élément frontal ou du connecteur frontal (7,8 ou 25,26), et un dispositif de fermeture (15,27), caractérisé par un dispositif de contact d'extrémité (14,39) situé sur l'autre extrémité (7,25) du système d'enfichage frontal pour la transmission des signaux pouvant être prélevés au moyen du connecteur frontal (20), à ce connecteur, et dans lequel, après enfichage du connecteur frontal (20) jusqu'à ce que le point d'accrochage du dispositif de fermeture (15,27) soit atteint et que les contacts de travail soient fermés, le dispositif de contact d'extrémité (14,39) engrènent uniquement après que, sur la base d'une commande du dispositif de fermeture, le connecteur frontal (20) soit complètement enfiché sur l'élément frontal (1).

2. Système d'enfichage frontal suivant la revendication 1, caractérisé par le fait que le dispositif de fermeture est disposé sur l'autre extrémité (7,25) du système d'enfichage frontal.

3. Système d'enfichage frontal suivant la revendication 2, caractérisé par au moins une vis (27), qui traverse le connecteur frontal (20) et comporte un taraudage (15) disposé en vis-à-vis dans l'élément frontal (1) et servant de dispositif de fermeture, la vis (28) faisant saillie hors du connecteur frontal au point que, lors de la venue en contact de l'extrémité de la vis à l'entrée du taraudage, tous les contacts de travail sont fermés et le dispositif de contact d'extrémité n'engrène que lorsque la vis est complètement vissée dans le taraudage (figures 1 à 4).

4. Système d'enfichage frontal suivant l'une des revendications précédentes, caractérisé par un dispositif de logement en forme de fente (3), notamment pour les couteaux de contact des contacts électriques de travail, dans lequel s'engage, après enfichage du connecteur frontal sur l'élément frontal, un dispositif de logement (24), qui fait saillie en forme de barrette, notamment pour les ressorts de contact, disposés de façon complémentaire, des contacts électriques de travail (figures 1 et 3).

5. Système d'enfichage frontal suivant la revendication 4 comportant un dispositif de contact d'extrémité, caractérisé par le fait que le contact de travail situé sur l'autre extrémité (7,25) du système d'enfichage frontal est disposé en retrait par rapport aux autres contacts de travail et n'engrène que lors de l'actionnement du dispositif de fermeture (figures 1 et 2).

6. Système d'enfichage frontal suivant l'une des revendications précédentes 1 à 4 comportant un autre dispositif de logement (11) disposé sur l'élément frontal (1) et prévu pour des éléments (12) d'affichage pour des signaux, de préférence des diodes à luminescence (41), et qui est masqué lorsque le connecteur frontal (20) est enfiché, caractérisé par des perçages (33) ménagés dans le connecteur frontal (20), situés en vis-à-vis des éléments d'affichage (12) à l'état enfiché et rendant ce dernier visible, le dispositif de contact d'extrémité (14,34) étant utilisé à la place d'un élément d'affichage situé sur l'autre extrémité (7,25) du système d'enfichage frontal (figures 3 et 4).

7. Système d'enfichage frontal suivant la revendication 6, comportant un dispositif de contact d'extrémité, caractérisé par
   a) une pièce de contact antagoniste (14) formée par un corps isolant (45) adapté à la forme de l'un des éléments d'enfichage et comportant des conducteurs électriques d'alimentation (46,47) disposés sur sa surface de contact (50), et
   b) une tige de contact de préférence cylindrique (39) dans laquelle est insérée une pièce élastique de contact (34), la tige de contact étant supportée, sur le côté tourné vers l'élément frontal (1), dans le perçage (35) situé sur l'autre extrémité (25) du connecteur frontal. (Figures 5 à 8).

8. Système d'enfichage frontal suivant l'une des revendications 6 et 7, caractérisé par le fait que dans le connecteur frontal, en dehors des perçages (35) servant à loger la tige de contact (39), tous les perçages (33) sont remplis par un guide de lumière, constitué notamment par une matière plastique vitreuse.

FIG 1

FIG 2

FIG 4

FIG 3

FIG 5

FIG 6

FIG 7

FIG 8